# EUROPEAN PATENT SPECIFICATION

(11) **EP 4 206 859 B1**
(45) Date of publication and mention of the grant of the patent: **31.12.2025**
(21) Application number: 22205262.3
(22) Date of filing: 03.11.2022
(51) Int. Cl.: G06F 1/16, H04M 1/02

(54) **DISPLAY DEVICE**
ANZEIGEVORRICHTUNG
DISPOSITIF D'AFFICHAGE

(30) Priority: 31.12.2021 KR 20210194333
(43) Date of publication of application: 05.07.2023
(73) Proprietor: LG Display Co., Ltd., Seoul 07336 (KR)
(72) Inventor: KIM, JunHyung, 10845 Paju-si, Gyeonggi-do (KR)
(74) Representative: Viering, Jentschura & Partner mbB Patent- und Rechtsanwälte

(56) References cited:
- EP-A2- 3 723 351
- US-A1- 2020 409 429
- US-A1- 2021 034 117

## Description

### BACKGROUND

### Field

The present disclosure relates to a foldable display apparatus, and more particularly, to a foldable display apparatus which has an inner-foldable hinge structure.

### Description of the Related Art

Recently, mobile terminals such as a wireless terminal, a personal digital assistant (PDA), a portable multimedia player (PMP), or an electronic notebook are being small-sized to ensure portability. However, since a user wants to receive various information such as character information, videos, still images, MP3, or games through a screen of the portable terminal, the user requires a large-sized or a wide-sized screen for the display unit. However, the reduction of the portable terminal results in reduction in the size of the screen of the display unit, so that there are limitations for satisfying both requirements.

In order to overcome the above-mentioned limitations, recently, a flexible display device such as a bendable display device or a foldable display device is being developed.

The flexible display device may be implemented by configuring a substrate with a plastic material. When the flexible display device is folded, it is simply carried and when the flexible display device is unfolded, a large screen is implemented so that the flexible display device may be applied to various fields including not only mobile equipment such as a mobile phone, an electronic book, or electronic newspaper, but also a television or a monitor.

Further, EP 3 723 351 A2 discloses a foldable electronic device, which includes a housing including a first part and a second part, a flexible display seated on the first part and the second part, and a hinge structure configured to fold and unfold the first part and the second part of the housing, wherein the hinge structure includes a hinge member including a sliding part and a connection part extending from the sliding part and connected to the first part or the second part, a guide member, and a hinge housing covering the hinge member and the guide member, wherein the guide member is fastened to the hinge housing to form a space with the hinge housing, and the sliding part is received in the space and performs a sliding motion between the guide member and the hinge housing. Further foldable display apparatuses are known from US 2020 / 409429 A1 and US 2021 / 034117 A1.

### SUMMARY

The inventors of the present disclosure invented a structure which used equipment configured by a hinge in an area where the display panel is folded, to implement a foldable display apparatus, among flexible display devices. However, the inventors recognized that in accordance with the recent increased demands for a large size in the field of foldable display apparatuses, it was difficult to satisfy the rigidity of the large size foldable display apparatus with the hinge structure of the related art.

Accordingly, an object to be achieved by the present disclosure is to provide a foldable display apparatus with an excellent durability by improving the rigidity of the hinge structure while simplifying the assembly structure.

Further, another object to be achieved by the present disclosure is to provide a foldable display apparatus with an inner-foldable hinge structure which may ensure the durability without increasing the thickness of the foldable display apparatus.

Further, still another object to be achieved by the present disclosure is to provide a foldable display apparatus which applies a hinge structure for suppressing the reverse folding.

Objects of the present disclosure are not limited to the above-mentioned objects, and other objects, which are not mentioned above, can be clearly understood by those skilled in the art from the following descriptions.

According to an aspect of the present disclosure, there is provided a foldable display apparatus according to claim 1. Further embodiments are described in the dependent claims.

Other detailed matters of the exemplary embodiments are included in the detailed description and the drawings.

According to the present disclosure, the durability may be ensured without increasing the thickness of the foldable display apparatus.

According to the present disclosure, components of the foldable display apparatus are minimized and a structure thereof is simplified while improving the durability to improve the price competitiveness.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIGS. 1A to 1C are perspective views of a foldable display apparatus according to an exemplary embodiment of the present disclosure;
FIG 2 is a schematic exploded perspective view of a foldable display apparatus according to an exemplary embodiment of the present disclosure;
FIG 3 is a perspective view of a housing frame of a foldable display apparatus according to an exemplary embodiment of the present disclosure;
FIG 4A is a schematic exploded perspective view of a hinge assembly of a foldable display apparatus according to an exemplary embodiment of the present disclosure;
FIG 4B is a schematic sectional perspective view of a hinge assembly of a foldable display apparatus according to an exemplary embodiment of the present disclosure;
FIGS. 5A and 5B are schematic exploded perspective views of some components of a hinge assembly of a foldable display apparatus according to an exemplary embodiment of the present disclosure;
FIG. 6A is a schematic perspective view of some components of a hinge assembly of a foldable display apparatus according to an exemplary embodiment of the present disclosure;
FIG. 6B is a sectional perspective view taken along the line A-A' of FIG. 6A;
FIG. 6C is a cross-sectional view taken along A-A' of FIG. 6A;
FIGS. 7A and 7B are schematic perspective views of some components of a hinge assembly of a foldable display apparatus according to an exemplary embodiment of the present disclosure which is unfolded; and
FIGS. 8A and 8B are schematic perspective views of some components of a hinge assembly of a foldable display apparatus according to an exemplary embodiment of the present disclosure which is folded.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a foldable display device according to exemplary embodiments of the present disclosure will be described in detail with reference to accompanying drawings.

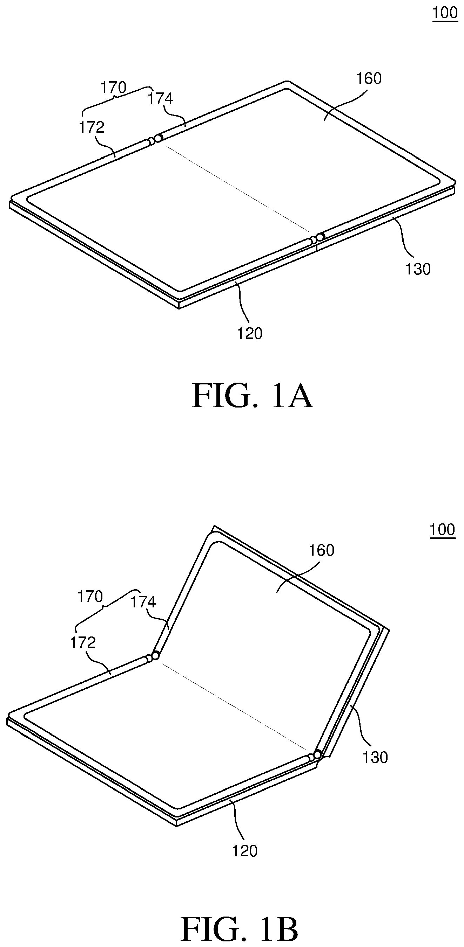

FIGS. 1A to 2 are views for explaining a foldable display apparatus according to an exemplary embodiment of the present disclosure.

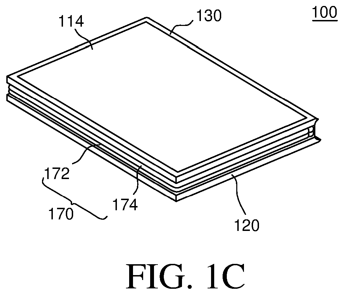

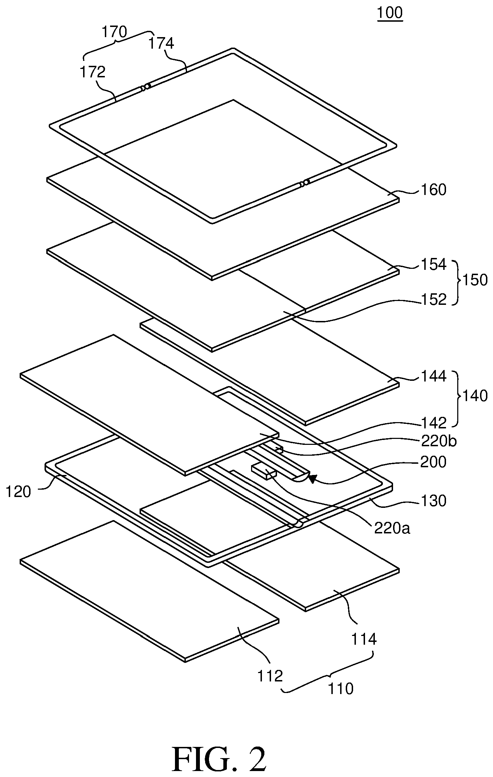

FIGS. 1A to 1C are perspective views of a foldable display apparatus 100 according to an exemplary embodiment of the present disclosure. FIG. 1A is a perspective view of the foldable display apparatus which is unfolded (stretched). FIG. 1B is a perspective view of the foldable display apparatus which is partially folded (bent). FIG. 1C is a perspective view of the foldable display apparatus which is fully folded (bent). FIG. 2 is a schematic exploded perspective view of a foldable display apparatus according to an exemplary embodiment of the present disclosure.

When the foldable display apparatus 100 according to the exemplary embodiment of the present disclosure is folded, an inner folding manner in which the display panel is located inside may be implemented, but is not limited thereto.

Referring to FIGS. 1A to 2, the foldable display apparatus 100 according to the exemplary embodiment of the present disclosure includes a housing cover 110, a housing frame, a hinge assembly 200, a hardware module 140, a mid frame 150, a display panel 160, and a bezel cover 170.

In FIGS. 1A to 2, even though components of the foldable display apparatus 100 is briefly illustrated for the convenience of description, actually, various components for driving the foldable display apparatus 100 may be further included.

The housing cover 110 which is a cover located at the bottom of the set may be a base member for supporting various components of the foldable display apparatus 100 including the display panel 160. Further, the housing cover 110 may accommodate various components for driving the foldable display apparatus 100. The housing cover 110 may be configured by a first cover 112 at the left side and a second cover 114 at the right side, but is not limited thereto.

The first cover 112 and the second cover 114 may be disposed in one area and the other area where the foldable display apparatus 100 is folded and unfolded, respectively. That is, the foldable display apparatus 100 according to the exemplary embodiment of the present disclosure is folded or unfolded with respect to a boundary area of the first cover 112 and the second cover 114 by an external force which is applied by a user to perform a folding movement.

The first cover 112 and the second cover 114 may be provided with the same shape.

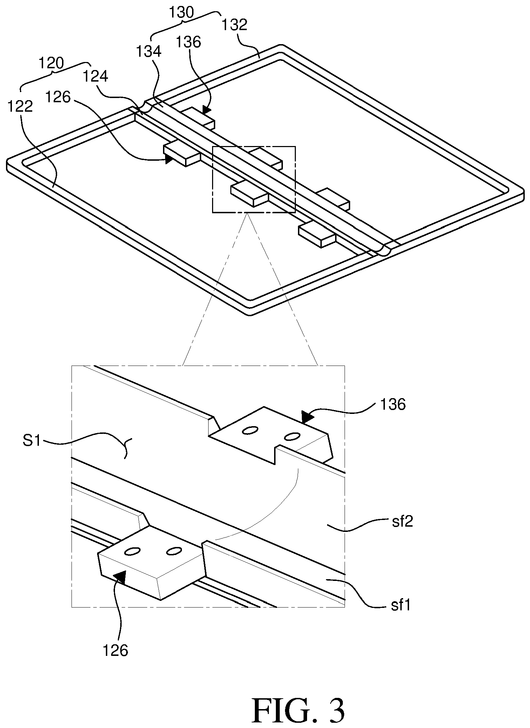

Hereinafter, a specific structure and function of a housing frame of the present disclosure will be described in detail with reference to FIG. 3.

FIG. 3 is a perspective view of a housing frame of a foldable display apparatus 100 according to an exemplary embodiment of the present disclosure.

The housing frames 120 and 130 are external frames of a set to mount various hardware components of the foldable display apparatus 100 therein. The display panel 160 is mounted in the housing frames.

The housing frames 120 and 130 may be configured by a first housing frame 120 at the left side and a second housing frame 130 at the right side, but are not limited thereto. The first housing frame 120 and the second housing frame 130 may be separately provided to be independently folded.

The first housing frame 120 and the second housing frame 130 enclose the edges of the first cover 112 and the second cover 114, respectively, to fix the first cover 112 and the second cover 114. Further, the first housing frame 120 and the second housing frame 130 may enclose edges of a first module 142 and a second module 144 to fix the first module 142 and the second module 144 and enclose edges of a first mid frame 152 and a second mid frame 154 to fix the first mid frame 152 and the second mid frame 154. Even though it is not illustrated in the drawing, the first housing frame 120 and the second housing frame 130 may include fastening units to be coupled to the first cover 112 and the second cover 114, respectively.

The first housing frame 120 and the second housing frame 130 may include an outer frame and an inner frame, respectively. The outer frame refers to a frame disposed on three surfaces exposed to the outside in an unfolded state of the foldable display apparatus 100. The inner frame refers to a frame located inside passing through the center of the foldable display apparatus 100 in the unfolded state of the foldable display apparatus 100. The first housing frame 120 includes a first outer frame 122 which encloses three edges of the first cover 112 and a first inner frame 124 which is in contact with the remaining edge of the first cover 112 located inside. The second housing frame 130 includes a second outer frame 132 which encloses three edges of the second cover 114 and a second inner frame 134 which is in contact with the remaining edge of the second cover 114 located inside. Referring to FIG. 3, the first inner frame 124 and the second inner frame 134 are disposed to abut against each other in the unfolded state of the foldable display apparatus 100.

Referring to FIG. 3, the first inner frame 124 includes a first curved surface sf1 formed in a direction adjacent to the second inner frame 134 and the second inner frame 134 includes a second curved surface sf2 formed in a direction adjacent to the first inner frame 124. In the unfolded state of the foldable display apparatus 100, the first inner frame 124 and the second inner frame 134 abut against each other so that the first curved surface sf1 of the first inner frame 124 and the second curved surface sf2 of the second inner frame 134 form one accommodation space S1. The hinge assembly 200 to be described below may be seated in the accommodation space S1 formed by the first inner frame 124 and the second inner frame 134.

Further, the first housing frame 120 and the second housing frame 130 may include a first fastening unit 126 and a second fastening unit 136 coupled to the hinge assembly 200, respectively. The first fastening unit 126 is formed in the first inner frame 124 of the first housing frame 120 and the second fastening unit 136 is formed in the second inner frame 134 of the second housing frame 130. The first fastening unit 126 is formed on the other side of the first curved surface sf1 of the first inner frame 124, that is, on a surface directed to the inside of the first housing frame 120. The second fastening unit 136 is formed on the other side of the second curved surface sf2 of the second inner frame 134, that is, on a surface directed to the inside of the second housing frame 130. The first fastening unit 126 and the second fastening unit 136 are fastened with a first hinge arm 220a and a second hinge arm 220b of the hinge assembly 200 to be described below. The first fastening unit 126 and the second fastening unit 136 may be alternately disposed.

The first housing frame 120 and the second housing frame 130 according to the exemplary embodiment of the present disclosure may be disposed in one area and the other area in which the foldable display apparatus 100 is folded and unfolded. That is, the foldable display apparatus 100 may perform the folding and unfolding movement with respect to a boundary area of the first housing frame 120 and the second housing frame 130 by an external force applied by a user.

The hinge assembly 200 is coupled to the housing frame to fold and unfold the foldable display apparatus 100.

The hinge arms 220a and 220b may couple the first fastening unit 126 of the first housing frame 120 and the second fastening unit 136 of the second housing frame 130 to each other. One or more hinge arms 220a and 220b of the hinge assembly 200 may be provided as needed. Even though in FIG. 2, it is illustrated that hinge arms 220a and 220b are provided at one side and the other side of the hinge assembly 200, it is not limited thereto.

Specifically, a pair of hinge arms 220a and 220b may couple one side and the other side of the first fastening unit 126 and the second fastening unit 136, respectively.

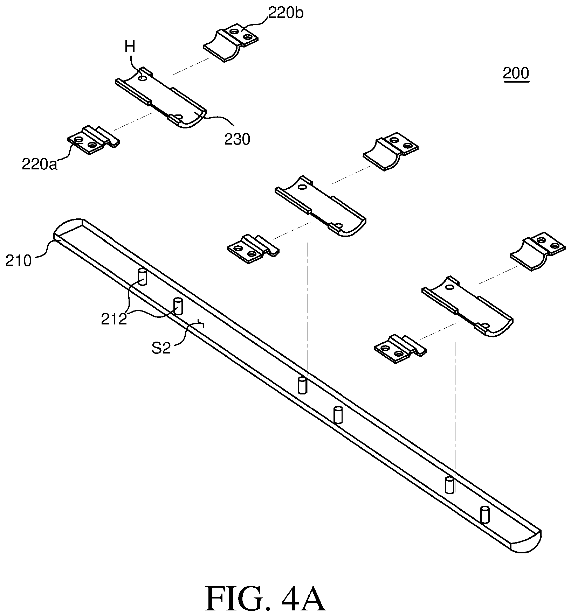

As described above, the hinge assembly 200 is disposed in a portion where the foldable display apparatus 100 is folded and unfolded to allow the foldable display apparatus 100 to be easily folded and unfolded. A specific structure and function of the hinge assembly 200 will be described below with reference to FIGS. 4A to 8B.

The hardware module 140 is a module necessary to operate the display panel 160 of the foldable display apparatus 100 and is disposed between the housing cover 110 and the mid frame 150 to be seated from the housing frame.

The hardware module 140 may be configured by a first module 142 at the left side and a second module 144 at the right side, but is not limited thereto. The first module 142 and the second module 144 may be separately provided to be independently folded. For example, the first module 142 may be a main board which transmits a signal to the display panel 160 or receives a signal from the display panel 160 to control the display panel 160. Further, the second module 144 may be a battery which supplies a power to the display panel 160.

The mid frame 150 is disposed to be opposite to the housing cover 110 to accommodate the hardware module 140 of the foldable display apparatus 100 located therebelow and support the display panel 160 located thereabove.

The mid frame 150 may be configured by a first mid frame 152 at the left side and a second mid frame 154 at the right side, but is not limited thereto. The first mid frame 152 and the a second mid frame 154 may be separately provided to be independently folded.

The first mid frame 152 and the a second mid frame 154 according to the exemplary embodiment of the present disclosure may be disposed in one area and the other area in which the foldable display apparatus 100 is folded and unfolded. That is, the foldable display apparatus 100 may perform the folding and unfolding movement with respect to a boundary area of the first mid frame 152 and the a second mid frame 154 by an external force applied by a user.

The display panel 160 may be disposed on an upper surface of the mid frame 150. The display panel 160 may use any one of various display panels 160 such as an organic light emitting display panel or a liquid crystal display panel.

Even though it is not illustrated in the drawings, the display panel 160 is a configuration for displaying images to the user and includes a plurality of sub pixels. In the display panel 160, the plurality of scan lines and the plurality of data lines intersect and each of the plurality of sub pixels may be connected to the scan line and the data line. In addition, each of the plurality of sub pixels may be connected to the high potential power line, the low potential power line, the initialization signal line, and the emission control signal line.

The sub pixel is a minimum unit which configures a screen and each of the plurality of sub pixels may include a light emitting diode and a driving circuit for driving the light emitting diode. The plurality of light emitting diodes may be defined in different ways depending on a type of the display panel 160. For example, when the display panel 160 is an organic light emitting display panel 160, the light emitting diode may be an organic light emitting diode which includes an anode, a light emitting unit, and a cathode. Hereinafter, even though the description will be made under the assumption that the light emitting diode is the organic light emitting diode, the type of the light emitting diode is not limited thereto.

A pixel circuit is a circuit for controlling the driving of the light emitting diode. For example, the pixel circuit may be configured to include a plurality of transistors and a capacitor, but is not limited thereto.

Further, the display panel 160 may have flexibility so as to be folded and unfolded in accordance with the folding and unfolding of the foldable display apparatus 100.

The foldable display apparatus 100 may be folded such that the first housing frame 120 and the second housing frame 130 form a specific folding angle. For example, in FIG. 1A, it is illustrated that the first housing frame 120 and the second housing frame 130 are fully unfolded with an angle of 180°. In contrast, in FIG. 1B, it is illustrated that the foldable display apparatus 100 is folded at a specific angle. In this case, the display panel 160 disposed above the first housing frame 120 and the second housing frame 130 is also folded at a specific angle together with the folding of the first housing frame 120 and the second housing frame 130. Moreover, in FIG. 1C, it is illustrated that the foldable display apparatus 100 is fully folded such that the first housing frame 120 and the second housing frame 130 abut against each other.

Further, the foldable display apparatus 100 may maintain a specific folding angle by the holding force supplied from the hinge assembly 200. That is, the first housing frame 120 and the second housing frame 130 may be fixed while maintaining a specific folding angle by the hinge assembly 200. Therefore, the foldable display apparatus 100 is folded at a specific angle as intended by the user and maintains a folded state at the specific angle by the holding force of the hinge.

The bezel cover 170 covers an upper bezel of the display panel 160 on the upper surface of the display panel 160.

The bezel cover 170 may be configured by a first bezel cover 172 at the left side and a second bezel cover 174 at the right side, but is not limited thereto.

Hereinafter, the specific structure and function of the hinge assembly 200 of the present disclosure will be described in detail with reference to FIGS. 4A to 6C.

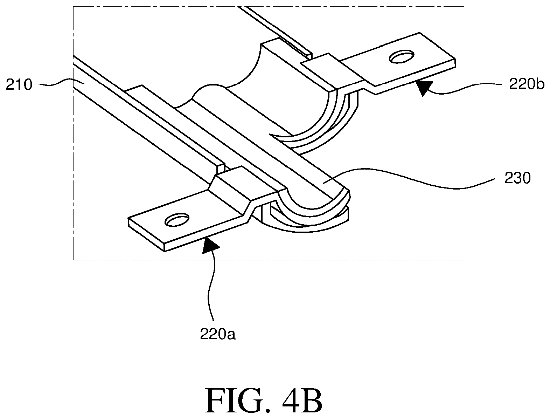

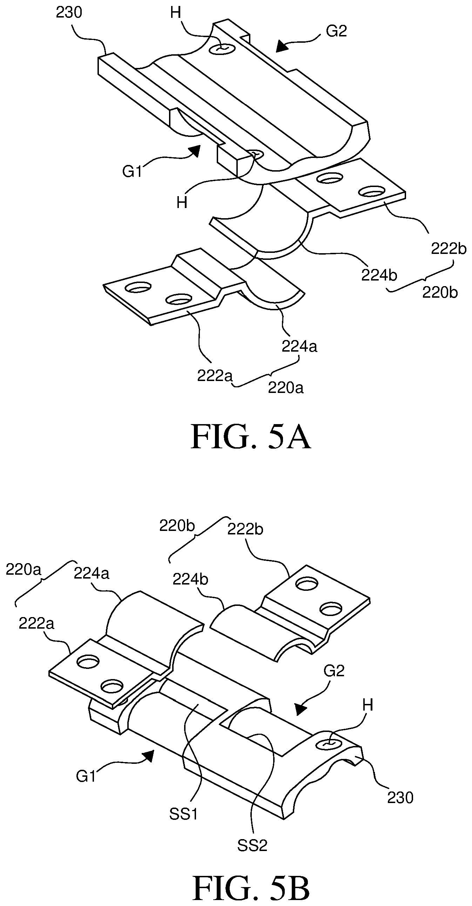

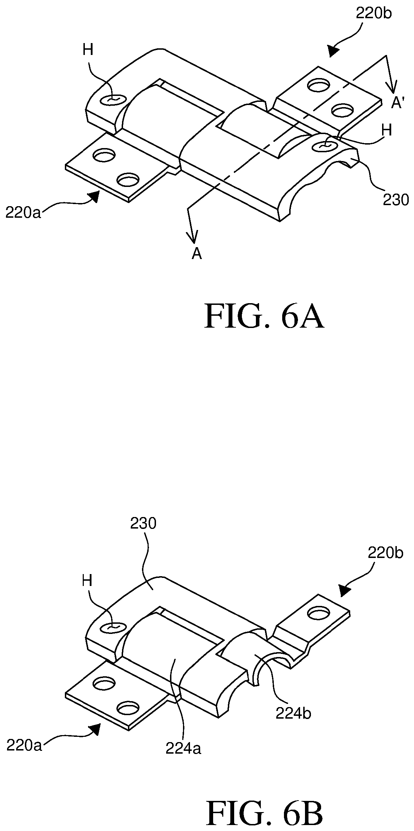

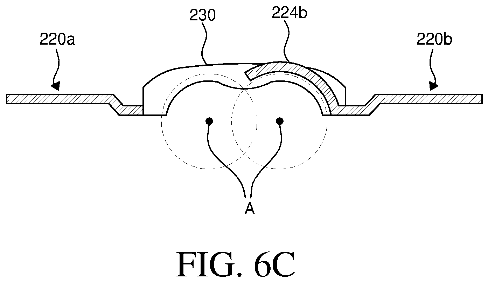

FIG. 4A is a schematic exploded perspective view of a hinge assembly 200 of a foldable display apparatus 100 according to an exemplary embodiment of the present disclosure. FIG. 4B is a schematic sectional perspective view of a hinge assembly 200 of a foldable display apparatus 100 according to an exemplary embodiment of the present disclosure. FIGS. 5A and 5B are schematic exploded perspective views of some components of a hinge assembly 200 of a foldable display apparatus 100 according to an exemplary embodiment of the present disclosure. FIG. 6A is a schematic perspective view of some configurations of a hinge assembly 200 of a foldable display apparatus 100 according to an exemplary embodiment of the present disclosure. FIG. 6B is a sectional perspective view taken along the line A-A' of FIG. 6A. FIG. 6C is a cross-sectional view taken along A-A' of FIG. 6A.

Referring to FIGS. 4A and 4B, the hinge assembly 200 of the foldable display apparatus 100 according to the exemplary embodiment of the present disclosure may be configured by a hinge housing 210, hinge arms 220a and 220b, and an arm cover 230.

The hinge housing 210 is an external cover of the hinge assembly 200 and has a predetermined length. The hinge housing 210 may accommodate the hinge arms 220a and 220b and the arm cover 230 located thereabove.

The hinge housing 210 may have a predetermined accommodation space S2 and has a semi-cylindrical shape with a concave upper surface. Accordingly, the hinge arms 220a and 220b and the arm cover 230 may be accommodated in the accommodation space S2 of the hinge housing 210.

The hinge housing 210 may include a fixing member 212 to fix the arm cover 230. The fixing member 212 has a shape protruding from the upper surface of the hinge housing 210 to a direction opposite to the arm cover 230. At this time, the fixing member 212 may be fastened with a fixing groove H formed on the arm cover 230. The fixing member 212 may have the fixing groove to be fastened with the arm cover 230 by means of a fastening member, such as a screw, to be fixed.

Referring to FIGS. 2 and 3, the hinge housing 210 is disposed such that the rear surface faces the housing frame and the upper surface faces the mid frame. At this time, the rear surface of the hinge housing 210 is disposed to be opposite to the accommodation space S1 of the housing frame formed by the first housing frame 120 and the second housing frame 130 which abut against each other. That is, the hinge housing 210 may be disposed so that at least a part thereof is seated in the accommodation space S1 of the housing frame.

The hinge arms 220a and 220b couple the hinge assembly 200 and the housing frame to each other to fold and unfold the housing frame with respect to the hinge assembly 200.

A plurality of hinge arms 220a and 220b may be configured. Specifically, referring to FIG. 4A, it is illustrated that three hinge arms 220a and 220b are provided at one side and the other side of the hinge assembly 200, respectively. The hinge arms 220a and 220b may be configured by a first hinge arm 220a at the left side and a second hinge arm 220b at a right side, but are not limited thereto. A plurality of first hinge arms 220a and a plurality of second hinge arms 220b may be configured. Accordingly, the plurality of first hinge arms 220a is disposed at the left side of the hinge housing 210 and the plurality of second hinge arms 220b is disposed at the right side of the hinge housing. The pair of first hinge arm 220a and second hinge arm 220b may be alternately disposed to be adjacent to each other.

The hinge arms 220a and 220b include fixing units 222a and 222b which are coupled to the fastening unit of the housing frame and rotary units 224a and 224b which rotatably move between the hinge housing 210 and the arm cover 230. Specifically, the first hinge arm 220a includes a first fixing unit 222a which is coupled to the first fastening unit 126 of the first housing frame 120 and the second hinge arm 220b includes a second fixing unit 222b which is coupled to the second fastening unit 136 of the second housing unit 130. The fixing units of the hinge arms 220a and 220b couple the hinge assembly 220 to the housing frame to fold and unfold the housing frame and other components accommodated in the housing frame in accordance with the movement of the hinge assembly 200.

Referring to FIGS. 5A and 5B, the rotary units 224a and 224b have a curved shape to have an arc corresponding to the accommodation space S2 of the hinge housing 210. Further, the rotary units 224a and 224b have a shape curved to have an arc corresponding to the guide unit of the arm cover 230. The first hinge arm 220a includes a first rotary unit 224a corresponding to a first guide unit G1 of the arm cover 230 and the second hinge arm 220b includes a second rotary unit 224b corresponding to a second guide unit G2 of the arm cover 230.

The first rotary unit 224a of the first hinge arm 220a and the second rotary unit 224b of the second hinge arm 220b may be alternately disposed.

Referring to FIG. 6C, the first rotary unit 224a and the second rotary unit 224b form a predetermined arc with respect to each of one pair of rotary axes A. Accordingly, during a folding or unfolding movement of the foldable display apparatus 100, the first rotary unit 224a and the second rotary unit 224b rotate around the pair of rotary axes A so that the first hinge arm 220a and the second hinge arm 220b rotate together.

The arm cover 230 is an external cover of the hinge assembly 200 to be disposed to be opposite to the hinge housing 210. The arm cover 230 is disposed above the hinge arms 220a and 220b to guide a rotary motion of the hinge arms 220a and 220b.

The arm cover 230 has a predetermined length to cover the hinge arms 220a and 220b. Referring to FIGS. 4A and 5A, the arm cover 230 is illustrated to cover one first hinge arm 220a and one second hinge arm 220b, but is not limited thereto. For example, the arm cover 230 may have a structure extending so as to simultaneously cover the plurality of first hinge arms 220a and the plurality of second hinge arms 220b and may have a length corresponding to the hinge housing 210 located therebelow.

The arm cover 230 may have a structure with a concave upper surface. Unlike the hinge housing 210 with a semicylindrical shape having one central axis, an upper surface of the arm cover 230 has two central axes to have two cylindrical surfaces.

The arm cover 230 may have a fixing groove H to be fixed to the hinge housing 210. Referring to FIG. 4A, the fixing groove H is formed in the arm cover 230 so as to be opposite to the fixing member 212 of the hinge housing 210.

The arm cover 230 includes a recessed guide unit which accommodates the rotary units of the hinge arms 220a and 220b and rotatably moves the rotary units. The guide unit has a structure partially recessed from the rear surface of the arm cover 230 so as to have an arc corresponding to the rotary units of the hinge arms 220a and 220b. Therefore, the rotary unit of the hinge arm is disposed between the hinge housing 210 and the arm cover 230 and is accommodated in the guide unit of the arm cover 230.

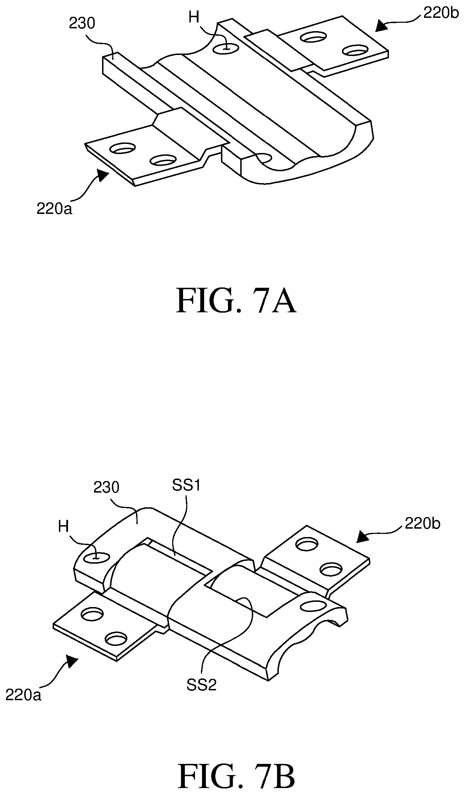

Hereinafter, a structure and an movement of the hinge arms 220a and 220b and the arm cover 230 when the foldable display apparatus 100 is folded and unfolded will be described in detail with reference to FIGS. 7A to 8B.

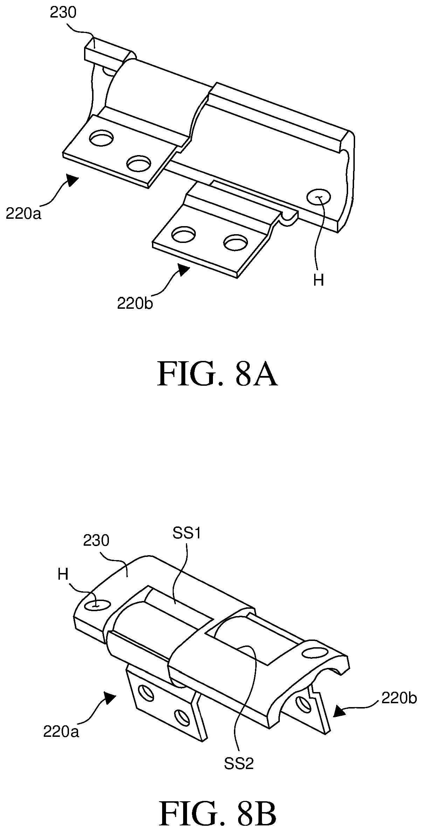

FIGS. 7A and 7b are schematic perspective views of some components of a hinge assembly 200 of a foldable display apparatus 100 according to an exemplary embodiment of the present disclosure which is unfolded. FIGS. 8A and 8b are schematic perspective views of some components of a hinge assembly 200 of a foldable display apparatus 100 according to an exemplary embodiment of the present disclosure which is folded. FIGS. 7A and 8A are views seen from the top and FIGS. 7B and 8B are views seen from the bottom.

Referring to FIGS. 7A and 7B, the hinge arms 220a and 220b are disposed to correspond to the guide unit of the hinge cover. Specifically, the first hinge arm 220a is disposed below the first guide unit G1 of the hinge cover and the second hinge arm 220b is disposed below the second guide unit G2. At this time, one end of the first rotary unit 224a of the first hinge arm 220a is disposed to abut against a step portion SS1 of the first guide unit G1 and one end of the second rotary unit 224b of the second hinge arm 220b is disposed to abut against a step portion SS2 of the second guide unit G2. The ends of the first rotary unit 224a and the second rotary unit 224b are disposed to be in contact with the step portions ss1 and ss2 to suppress the outer-folding of the display panel 160.

Referring to FIGS. 8A and 8B, during the folding, the rotary units of the hinge arms 220a and 220b rotate along the guide unit G1 and G2 of the hinge cover 230. That is, an inner surface of the first rotary unit 224a of the first hinge arm 220a moves along the first guide unit G1 while being in contact with one surface of the first guide unit G1 of the hinge cover. By doing this, in the foldable display apparatus 100 product, the first hinge arm 220a and the second hinge arm 220b may be inwardly folded.

The first hinge arm 220a and the second hinge arm 220b independently rotatably move along the first guide unit G1 and the second guide unit G2 to be biaxially folded. That is, the first hinge arm 220a and the second hinge arm 220b may rotate around one pair of rotary axes A defined by the first guide unit G1 and the second guide unit G2.

The foldable display apparatus according to the exemplary embodiment of the present disclosure uses a hinge assembly configured by a hinge housing, a hinge arm, and an arm cover to provide a foldable display apparatus which is biaxially foldable while minimizing the components. The component and the structure are simplified to improve the price competitiveness of the foldable display apparatus. Further, the foldable display apparatus according to the exemplary embodiment of the present disclosure suppresses the reverse folding by means of the housing frame structure which accommodates the hinge assembly and improves the rigidity at both sides to ensure the durability.

The exemplary non-claimed embodiments of the present disclosure can also be described as follows:

According to an aspect of the present disclosure, there is provided a foldable display apparatus. The foldable display apparatus comprises a housing frame including a first frame and a second frame; a hinge assembly coupled to the first frame and the second frame to implement a folding and unfolding movement of the first frame and the second frame; and a display panel disposed on the first frame and the second frame. The hinge assembly includes a plurality of hinge arms coupled to the first frame and the second frame; a hinge housing which is disposed below the plurality of hinge arms and accommodates the plurality of hinge arms; and an arm cover which is fastened with the hinge housing to be disposed above the plurality of hinge arms and includes a plurality of guide units recessed to correspond to the plurality of hinge arms.

Each of the plurality of hinge arms may include a fixing unit coupled to the housing frame; and a rotary unit including a curved shape having an arc to rotatably move between the hinge housing and the arm cover.

The plurality of hinge arms may include a first hinge arm disposed at one side of the hinge housing and a second hinge arm disposed at the other side and the pair of first hinge arm and second hinge arm may be alternately disposed to be adjacent to each other.

The hinge housing may have a semicylindrical shape to have a predetermined accommodation space and the arm cover may have an upper surface on which two cylindrical surfaces are formed to have two central axes.

Each guide unit may have a shape recessed from a lower surface of the arm cover so as to accommodate at least a part of a respective one of the plurality of hinge arms and a lower surface of the guide unit may have an arc shape.

The foldable display apparatus may further comprise a first cover and a second cover disposed below the display panel. Each of the first frame and the second frame may include a first inner frame and a second inner frame which enclose inner sides of the first cover and the second cover and are disposed to be opposite to each other, and the first inner frame and the second inner frame may be in contact with each other in an unfolded state of the foldable display apparatus.

The first inner frame may include a first curved surface formed in a direction adjacent to the second inner frame, the second inner frame may include a second curved surface formed in a direction adjacent to the first inner frame, in an unfolded state of the foldable display apparatus, the first curved surface and the second curved surface may form an accommodation space, and the hinge assembly may be seated in the accommodation space.

The first frame may include a first fastening unit formed in the first inner frame, the second frame may include a second fastening unit formed in the second inner frame, and the first fastening unit is coupled to a first fixing unit of the first hinge arm and the second fastening unit may be coupled to a second fixing unit of the second hinge arm.

The foldable display apparatus may further comprise a main board module and a battery module disposed on the first cover and the second cover; a first mid frame and a second mid frame disposed on the main board module and the battery module; and a first bezel cover and a second bezel cover which cover an upper edge of the display panel. The first frame and the second frame may enclose the main board module and the battery module.

The plurality of guide units may include a first guide unit corresponding to a first rotary unit of the first hinge arm and a second guide unit corresponding to a second rotary unit of the second hinge arm, and the first rotary unit and the second rotary unit may rotate around one pair of different rotary axes defined by the first guide unit and the second guide unit, respectively.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims.

## Claims

1. A foldable display apparatus (100), comprising:
a housing frame (120, 130) including a first frame (120) and a second frame (130);
a hinge assembly (200) coupled to the first frame (120) and the second frame (130) to implement a folding and unfolding movement of the first frame (120) and the second frame (130); and
a display panel (160) disposed on the first frame (120) and the second frame (130),
wherein the hinge assembly (200) includes:
a plurality of hinge arms (220a, 220b) each coupled to one of the first frame (120) and the second frame (130);
a hinge housing (210) disposed below the plurality of hinge arms (220a, 220b) and accommodating the plurality of hinge arms (220a, 220b); and
an arm cover (230) disposed above the plurality of hinge arms (220a, 220b) and fastened with the hinge housing (210), the arm cover (230) including a plurality of recessed guide units (G1, G2) respectively corresponding to the plurality of hinge arms (220a, 220b),
wherein each guide unit (G1, G2) has a shape recessed from a lower surface of the arm cover (230) to accommodate at least a part of a respective one of the plurality of hinge arms (220a, 220b), and a lower surface of the guide unit (G1, G2) has an arc shape.

2. The foldable display apparatus (100) according to claim 1, wherein each of the plurality of hinge arms (220a, 220b) includes:
a fixing unit (222a, 222b) coupled to the housing frame (120, 130); and
a rotary unit (224a, 224b) having a curved shape to rotatably move between the hinge housing (210) and the arm cover (230).

3. The foldable display apparatus (100) according to claim 1 or 2, wherein the plurality of hinge arms (220a, 220b) includes a first hinge arm (220a) disposed at one side of the hinge housing (210) and a second hinge arm (220b) disposed at the other side of the hinge housing (210), and the pair of first hinge arm (220a) and second hinge arm (220b) is alternately disposed to be adjacent to each other.

4. The foldable display apparatus (100) according to claim 3, wherein the plurality of guide units (G1, G2) includes a first guide unit (G1) corresponding to a first rotary unit (224a) of the first hinge arm (220a) and a second guide unit (G2) corresponding to a second rotary unit (224b) of the second hinge arm (220b), and
the first rotary unit (224a) and the second rotary unit (224b) rotate around one pair of different rotary axes (A) defined by the first guide unit (G1) and the second guide unit (G2), respectively.

5. The foldable display apparatus (100) according to claim 3 or 4, further comprising:
a first cover (112) and a second cover (114) disposed below the display panel (160),
wherein the first frame (120) and the second frame (130) respectively include a first inner frame (124) enclosing an inner side of the first cover (112) and a second inner frame (134) enclosing an inner side of the second cover (114), and
the first inner frame (124) and the second inner frame (134) are in contact with each other in an unfolded state of the foldable display apparatus (100).

6. The foldable display apparatus (100) according to claim 5, wherein the first inner frame (124) includes a first curved surface (sf1) formed in a direction adjacent to the second inner frame (134), the second inner frame (134) includes a second curved surface (sf2) formed in a direction adjacent to the first inner frame (124), in the unfolded state of the foldable display apparatus (100), the first curved surface and the second curved surface form an accommodation space (S1), and the hinge assembly (200) is disposed in the accommodation space.

7. The foldable display apparatus (100) according to claim 5 or 6, wherein the first frame (120) includes a first fastening unit (126) formed in the first inner frame (124), the second frame (130) includes a second fastening unit formed in the second inner frame (134), and the first fastening unit (126) is coupled to a first fixing unit (222a) of the first hinge arm (220a) and the second fastening unit is coupled to a second fixing unit (222b) of the second hinge arm (220b).

8. The foldable display apparatus (100) according to any of claims 5 to 7, further comprising:
a main board module (142) and a battery module (144) disposed on the first cover (112) and the second cover (114) respectively;
a first mid frame (152) and a second mid frame (154) disposed on the main board module (142) and the battery module (144) respectively; and
a first bezel cover (172) and a second bezel cover (174) covering an upper edge of the display panel (160),
wherein the first frame (120) and the second frame (130) enclose the main board module (142) and the battery module (144).

9. The foldable display apparatus (100) according to any of claims 1 to 8, wherein the hinge housing (210) has a semicylindrical shape with a predetermined accommodation space (S2) and the arm cover (230) has an upper surface including two cylindrical surfaces with two central axes.

10. The foldable display apparatus of any of claims 1 to 9, wherein the hinge housing (210) includes a fixing member (212),
and the arm cover (230) is fastened with the hinge housing (210) by the fixing member (212) and a fixing groove (H) formed on the arm cover (230).

## Patentansprüche

1. Faltbare Anzeigevorrichtung (100), aufweisend:
einen Gehäuserahmen (120, 130) aufweisend einen ersten Rahmen (120) und einen zweiten Rahmen (130),
eine Gelenkbaugruppe (200), die mit dem ersten Rahmen (120) und dem zweiten Rahmen (130) verbunden ist, um eine Falt- und Entfaltbewegung des ersten Rahmens (120) und des zweiten Rahmens (130) zu implementieren, und
ein Anzeigepanel (160), das auf dem ersten Rahmen (120) und dem zweiten Rahmen (130) angeordnet ist,
wobei die Gelenkbaugruppe (200) aufweist:
eine Mehrzahl von Gelenkarmen (220a, 220b), die jeweils mit einem von dem ersten Rahmen (120) und dem zweiten Rahmen (130) verbunden sind,
ein Gelenkgehäuse (210), das unter der Mehrzahl von Gelenkarmen (220a, 220b) angeordnet ist und die Mehrzahl von Gelenkarmen (220a, 220b) aufnimmt, und
eine Armabdeckung (230), die über der Mehrzahl von Gelenkarmen (220a, 220b) angeordnet ist und an dem Gelenkgehäuse (210) befestigt ist, wobei die Armabdeckung (230) eine Mehrzahl von vertieften Führungseinheiten (G1, G2) aufweist, die in zugeordneter Weise zu der Mehrzahl von Gelenkarmen (220a, 220b) korrespondieren,
wobei jede Führungseinheit (G1, G2) eine von einer unteren Fläche der Armabdeckung (230) zurückgesetzte Form hat, um mindestens einen Teil eines jeweiligen aus der Mehrzahl von Gelenkarmen (220a, 220b) aufzunehmen, und eine untere Fläche der Führungseinheit (G1, G2) eine Bogenform hat.

2. Faltbare Anzeigevorrichtung (100) gemäß Anspruch 1, wobei jeder aus der Mehrzahl von Gelenkarmen (220a, 220b) aufweist:
eine Fixiereinheit (222a, 222b), die mit dem Gehäuserahmen (120, 130) verbunden ist, und
eine Dreheinheit (224a, 224b), die eine gekrümmte Form hat, um sich zwischen dem Gelenkgehäuse (210) und der Armabdeckung (230) drehbar zu bewegen.

3. Faltbare Anzeigevorrichtung (100) gemäß Anspruch 1 oder 2, wobei die Mehrzahl von Gelenkarmen (220a, 220b) aufweist: einen ersten Gelenkarm (220a), der an einer Seite des Gelenkgehäuses (210) angeordnet ist, und einen zweiten Gelenkarm (220b), der an der anderen Seite des Gelenkgehäuses (210) angeordnet ist, und wobei das Paar aus dem ersten Gelenkarm (220a) und dem zweiten Gelenkarm (220b) abwechselnd angeordnet ist, um benachbart zueinander zu sein.

4. Faltbare Anzeigevorrichtung (100) gemäß Anspruch 3, wobei die Mehrzahl von Führungseinheiten (G1, G2) eine erste Führungseinheit (G1), die zu einer ersten Dreheinheit (224a) des ersten Gelenkarms (220a) korrespondiert, und eine zweite Führungseinheit (G2) aufweist, die zu einer zweiten Dreheinheit (224b) des zweiten Gelenkarms (220b) korrespondiert, und
die erste Dreheinheit (224a) und die zweite Dreheinheit (224b) sich um ein Paar unterschiedlicher Drehachsen (A) drehen, die in zugeordneter Weise durch die erste Führungseinheit (G1) und die zweite Führungseinheit (G2) definiert sind.

5. Faltbare Anzeigevorrichtung (100) gemäß Anspruch 3 oder 4, ferner aufweisend:
eine erste Abdeckung (112) und eine zweite Abdeckung (114), die unter dem Anzeigepanel (160) angeordnet sind,
wobei der erste Rahmen (120) und der zweite Rahmen (130) in zugeordneter Weise einen ersten Innenrahmen (124), der eine Innenseite der ersten Abdeckung (112) umschließt, und einen zweiten Innenrahmen (134) aufweisen, der eine Innenseite der zweiten Abdeckung (114) umschließt, und
der erste Innenrahmen (124) und der zweite Innenrahmen (134) in einem entfalteten Zustand der faltbaren Anzeigevorrichtung (100) miteinander in Kontakt sind.

6. Faltbare Anzeigevorrichtung (100) gemäß Anspruch 5, wobei der erste Innenrahmen (124) eine erste gekrümmte Fläche (sf1) aufweist, die in einer Richtung benachbart zum zweiten Innenrahmen (134) ausgebildet ist, der zweite Innenrahmen (134) eine zweite gekrümmte Fläche (sf2) aufweist, die in einer Richtung benachbart zum ersten Innenrahmen (124) ausgebildet ist, im entfalteten Zustand der faltbaren Anzeigevorrichtung (100) die erste gekrümmte Fläche und die zweite gekrümmte Fläche einen Aufnahmeraum (S1) bilden und die Gelenkbaugruppe (200) in dem Aufnahmeraum angeordnet ist.

7. Faltbare Anzeigevorrichtung (100) gemäß Anspruch 5 oder 6, wobei der erste Rahmen (120) eine erste Befestigungseinheit (126) aufweist, die im ersten Innenrahmen (124) ausgebildet ist, der zweite Rahmen (130) eine zweite Befestigungseinheit aufweist, die im zweiten Innenrahmen (134) ausgebildet ist, und die erste Befestigungseinheit (126) mit einer ersten Fixiereinheit (222a) des ersten Gelenkarms (220a) verbunden ist, und die zweite Befestigungseinheit mit einer zweiten Fixiereinheit (222b) des zweiten Gelenkarms (220b) verbunden ist.

8. Faltbare Anzeigevorrichtung (100) gemäß irgendeinem der Ansprüche 5 bis 7, ferner aufweisend:
ein Hauptplatinenmodul (142) und ein Batteriemodul (144), die in zugeordneter Weise auf der ersten Abdeckung (112) und der zweiten Abdeckung (114) angeordnet sind,
einen ersten Mittelrahmen (152) und einen zweiten Mittelrahmen (154), die in zugeordneter Weise auf dem Hauptplatinenmodul (142) und dem Batteriemodul (144) angeordnet sind, und
eine erste Blendenabdeckung (172) und eine zweite Blendenabdeckung (174), die einen oberen Rand des Anzeigepanels (160) abdecken,
wobei der erste Rahmen (120) und der zweite Rahmen (130) das Hauptplatinenmodul (142) und das Batteriemodul (144) umschließen.

9. Faltbare Anzeigevorrichtung (100) gemäß irgendeinem der Ansprüche 1 bis 8, wobei das Gelenkgehäuse (210) eine halbzylindrische Form mit einem vorbestimmten Aufnahmeraum (S2) hat und die Armabdeckung (230) eine obere Fläche hat, die zwei zylindrische Flächen mit zwei Mittelachsen aufweist.

10. Faltbare Anzeigevorrichtung gemäß irgendeinem der Ansprüche 1 bis 9, wobei das Gelenkgehäuse (210) ein Fixierelement (212) aufweist,
und die Armabdeckung (230) an dem Gelenkgehäuse (210) durch das Fixierelement (212) und eine an der Armabdeckung (230) ausgebildete Fixiernut (H) befestigt ist.

## Revendications

1. Dispositif d'affichage pliable (100), comprenant :
un cadre de boîtier (120, 130) comprenant un premier cadre (120) et un deuxième cadre (130) ;
un ensemble de charnière (200) couplé au premier cadre (120) et au deuxième cadre (130) pour mettre en œuvre un mouvement de pliage et de dépliage du premier cadre (120) et du deuxième cadre (130) ; et
un panneau d'affichage (160) disposé sur le premier cadre (120) et le deuxième cadre (130),
dans lequel l'ensemble de charnière (200) comprend :
une pluralité de bras de charnière (220a, 220b) couplés chacun à l'un des premier cadre (120) et deuxième cadre (130) ;
un boîtier de charnière (210) disposé sous une pluralité de bras de charnière (220a, 220b) et logeant la pluralité de bras de charnière (220a, 220b) ; et
un couvercle de bras (230) disposé au-dessus de la pluralité de bras de charnière (220a, 220b) et attaché au boîtier de charnière (210), le couvercle de bras (230) comprenant une pluralité d'unités de guidage en retrait (G1, G2) correspondant respectivement à la pluralité de bras de charnière (220a, 220b),
dans lequel chaque unité de guidage (G1, G2) a une forme en retrait par rapport à une surface inférieure du couvercle de bras (230) pour loger au moins une partie d'un respectif parmi la pluralité de bras de charnière (220a, 220b), et une surface inférieure de l'unité de guidage (G1, G2) a une forme arquée.

2. Dispositif d'affichage pliable (100) selon la revendication 1, dans lequel chacun de la pluralité de bras de charnière (220a, 220b) comprend :
une unité de fixation (222a, 222b) couplée au cadre de boîtier (120, 130) ; et
une unité rotative (224a, 224b) ayant une forme incurvée pour se déplacer de manière rotative entre le boîtier de charnière (210) et le couvercle de bras (230).

3. Dispositif d'affichage pliable (100) selon la revendication 1 ou 2, dans lequel la pluralité de bras de charnière (220a, 220b) comprend un premier bras de charnière (220a) disposé sur un côté du boîtier de charnière (210) et un deuxième bras de charnière (220b) disposé sur l'autre côté du boîtier de charnière (210), et la paire de premier bras de charnière (220a) et de deuxième bras de charnière (220b) est disposée en alternance de manière à être adjacente l'une à l'autre.

4. Dispositif d'affichage pliable (100) selon la revendication 3, dans lequel la pluralité d'unités de guidage (G1, G2) comprend une première unité de guidage (G1) correspondant à une première unité rotative (224a) du premier bras de charnière (220a) et une deuxième unité de guidage (G2) correspondant à une deuxième unité rotative (224b) du deuxième bras de charnière (220b), et
la première unité rotative (224a) et la deuxième unité rotative (224b) tournent autour d'une paire d'axes rotatifs différents (A) définis respectivement par la première unité de guidage (G1) et la deuxième unité de guidage (G2).

5. Dispositif d'affichage pliable (100) selon la revendication 3 ou 4, comprenant en outre :
un premier couvercle (112) et un deuxième couvercle (114) disposés sous le panneau d'affichage (160),
dans lequel le premier cadre (120) et le deuxième cadre (130) comprennent respectivement un premier cadre intérieur (124) entourant un côté intérieur du premier couvercle (112) et un deuxième cadre intérieur (134) entourant un côté intérieur du deuxième couvercle (114), et
le premier cadre intérieur (124) et le deuxième cadre intérieur (134) sont en contact l'un avec l'autre dans un état déplié du dispositif d'affichage pliable (100).

6. Dispositif d'affichage pliable (100) selon la revendication 5, dans lequel le premier cadre intérieur (124) comprend une première surface incurvée (sf1) formée dans une direction adjacente au deuxième cadre intérieur (134), le deuxième cadre intérieur (134) comprend une deuxième surface incurvée (sf2) formée dans une direction adjacente au premier cadre intérieur (124), dans l'état déplié du dispositif d'affichage pliable (100), la première surface incurvée et la deuxième surface incurvée forment un espace de logement (S1), et l'ensemble de charnière (200) est disposé dans l'espace de logement.

7. Dispositif d'affichage pliable (100) selon la revendication 5 ou 6, dans lequel le premier cadre (120) comprend une première unité d'attache (126) formée dans le premier cadre intérieur (124), le deuxième cadre (130) comprend une deuxième unité d'attache formée dans le deuxième cadre intérieur (134), et la première unité d'attache (126) est couplée à une première unité de fixation (222a) du premier bras de charnière (220a) et la deuxième unité d'attache est couplée à une deuxième unité de fixation (222b) du deuxième bras de charnière (220b).

8. Dispositif d'affichage pliable (100) selon l'une quelconque des revendications 5 à 7, comprenant en outre :
un module de carte mère (142) et un module de batterie (144) disposés respectivement sur le premier couvercle (112) et le deuxième couvercle (114) ;
un premier cadre intermédiaire (152) et un deuxième cadre intermédiaire (154) disposés respectivement sur le module de carte mère (142) et le module de batterie (144) ; et
un premier couvercle de bandeau (172) et un deuxième couvercle de bandeau (174) recouvrant un bord supérieur du panneau d'affichage (160),
dans lequel le premier cadre (120) et le deuxième cadre (130) renferment le module de carte mère (142) et le module de batterie (144).

9. Dispositif d'affichage pliable (100) selon l'une quelconque des revendications 1 à 8, dans lequel le boîtier de charnière (210) a une forme semi-cylindrique avec un espace de logement prédéterminé (S2) et le couvercle de bras (230) a une surface supérieure comprenant deux surfaces cylindriques avec deux axes centraux.

10. Dispositif d'affichage pliable selon l'une quelconque des revendications 1 à 9, dans lequel le boîtier de charnière (210) comprend un élément de fixation (212),
et le couvercle de bras (230) est attaché au boîtier de charnière (210) par l'élément de fixation (212) et une rainure de fixation (H) formée sur le couvercle de bras (230) .
